# EUROPEAN PATENT SPECIFICATION

(11) **EP 0 977 267 B1**
(45) Date of publication and mention of the grant of the patent: **04.07.2007**
(21) Application number: 98202563.7
(22) Date of filing: 30.07.1998
(51) Int. Cl.: H01L 27/115, H01L 29/788, H01L 21/8247, H01L 21/336

(54) **Non volatile memory structure and corresponding manufacturing process**
Nichtflüchtige Speicherstruktur und das entsprechende Herstellungsverfahren
Structure de mémoire non-volatile et le procédé de fabrication correspondant

(43) Date of publication of application: 02.02.2000
(73) Proprietor: STMicroelectronics S.r.l., 20041 Agrate Brianza (Milano) (IT)
(72) Inventor: Dalla Libera, Giovanna, 20052 Monza (IT); Pio, Federico, 20047 Brugherio (Milano) (IT)
(74) Representative: Botti, Mario

(56) References cited:
- EP-A- 0 002 997
- US-A- 5 338 969
- PATENT ABSTRACTS OF JAPAN vol. 017, no. 613 (E-1458), 11 November 1993 & JP 05 190809 A (KAWASAKI STEEL CORP), 30 July 1993
- PATENT ABSTRACTS OF JAPAN vol. 014, no. 550 (E-1009), 6 December 1990 & JP 02 237077 A (TOSHIBA CORP), 19 September 1990
- PATENT ABSTRACTS OF JAPAN vol. 018, no. 311 (E-1561), 14 June 1994 & JP 06 069464 A (ROHM CO LTD), 11 March 1994

## Description

### Background of the invention

The present invention relates to a non-volatile memory structure integrated on a semiconductor substrate and including a plurality of memory cells each comprising a floating gate transistor having an active area and source/drain regions as well as a control gate coupled to the floating gate, the floating gate transistor being serially connected to a selection transistor.

The invention relates also to a process for manufacturing the above memory structure.

As is well known in this specific technical field, double-poly technology for realizing the floating gate transistors of non volatile memories, such as EPROM, EEPROMS, or Flash-EEPROMs, is widely used in the manufacturing of integrated memory circuits.

According to the prior art, in order to realize a memory device including non volatile memory cells in a double-poly technology it's necessary to use a set of standard CMOS process masks and at least the following masks:
- POLY1 mask for defining the floating gates;
- MATRIX or interpoly dielectric mask which is used to remove the interpoly dielectric protection of the memory array;
- POLY2 or control gates mask for defining the poly lines which will form the control gates of the memory cells;

Other masks are usually necessary for manufacturing the specific kind of non volatile memory cells. For instance, a specific mask for N+ implant is required for EEPROMS, implant masks are required for Source and/or Drain junction engineering in Flash, or a Self-Aligned-Source mask is used to obtain a Source diffusion aligned to the polisilicon lines.

Since the mask count is a cost issue for economic production, also because the increasing number of metallization levels required for the interconnections is impacting the cycle-time in the production line, it would be desirable to reduce the number of masks to realize a non volatile memory cell, while maintaining the same cell features.

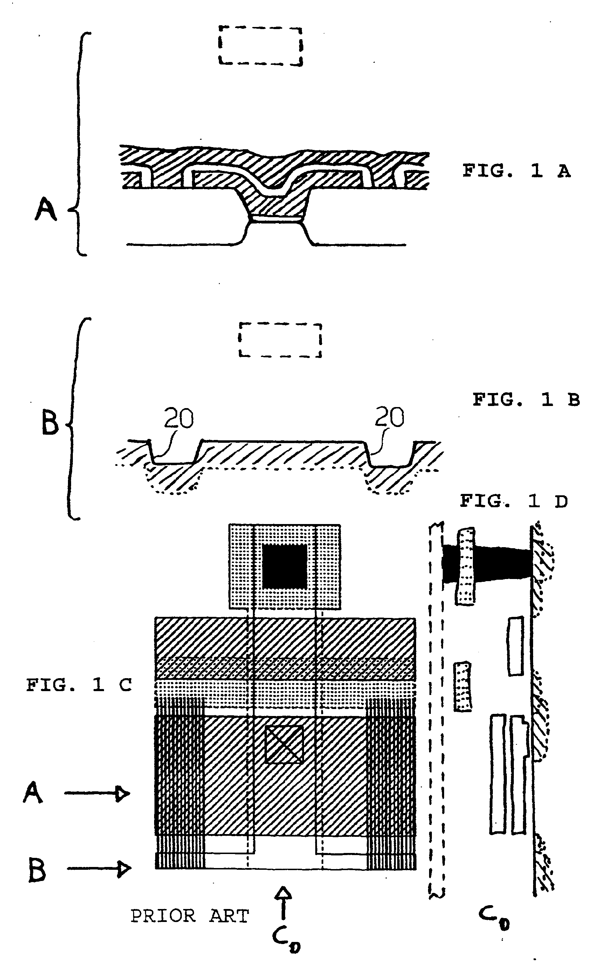

However, a problem specifically related to the manufacturing of non volatile memory cells with a compact layout concerns the need of the POLY1 mask. Making reference to the enclosed figure 1, it may be appreciated that this mask is used to cross the active area on the diffusion region used as Source line for the memory array.

As a matter of fact, the floating gates must be defined in a direction which is parallel to word lines and this is obtained by etching the poly1 layer with a sufficient extension beyond the future control gate line. In this manner, assuming a "self-aligned" process, any short between floating gates of adjacent cells is avoided when the floating gate is defined in the other direction by the poly2/interpoly/poly1 stack etching.

Therefore, in these regions wherein POLY1 is crossing the active areas no poly1 layer is left on the active area and during the stack etching a consistent substrate etching is provided, as shown in figure 1B by the trench indicated with the numeral 20. This substrate etching in unavoidable because poly2 etching can be stopped on interpoly dielectric, while the interpoly dielectric etch is stopped on poly1, but in these overlapping regions poly1 is not present and the etching is stopped only on the active area. This means that the interpoly dielectric etching is stopped on the silicon substrate, but during the poly1 etching the substrate is also etched.

For this reason, the source line will not be flat and, even if this is not a severe problem since N+ implant for source and drain can guarantee the electrical continuity of the source line, there is a serious drawback due to the fact that the source resistance is increased if compared to a typical N+ diffusion of a flat cross section.

Moreover, if the manufacturing process includes a phase of active area salicidation, as in most advanced technologies now used, the source line irregularity can cause further problems due to the metal (i.e. Ti) reaction with silicon.

More particularly, the metal reaction involves regions with a low doping concentration, such as the bottom corner of the etched source line portion, a short between the N+ diffused substrate region can occur.

The problem of silicon etching in the source line and the corresponding increase of the source resistance is particularly severe in the case of EEPROM memory devices for which the bits of the same byte must be adjacent for construction. Moreover, the control gates are separated at byte level in order to allow byte granularity both in Write and in Erase phases.

Since there is no possibility to divide the bits, there is an enhanced series resistance effect during the reading phase, because all the bits of the same byte can drain current and a correspondingly increased voltage drop on the source line occurs, the only possible solution proposed by the prior art would be that of introducing more frequent source contacts. However, this solution brings to a corresponding overall circuit area increase of the memory device.

A first object of the present invention is to solve any problem related to the substrate etching in the source line; the problem could be of a technological nature if related to salicidation or of an electrical nature if due to excessive source line resistivity.

A second object of the present invention is to provide a memory structure having control gate lines featuring with an intrinsic low resistivity. In fact, the control gate lines resistance related to the poly2 layer sheet resistivity is very important to reduce the access resistance and therefore the access time to the memory array.

A further aim of the invention is to provide a memory structure allowing a cell area reduction, without the need of a Self-Aligned-Source mask and, at the same time, avoiding the problem of potential dielectric breakdown between control gate line and source diffusion.

As a matter of fact, memory devices manufactured without a Self-Aligned-Source process and with an extra dedicated mask require a sufficient distance between the poly2 control gate and the source active area otherwise the control gate line can be directly overlapped on the diffusion with only interposition of the interpoly dielectric layer where the poly1 has been was removed. Since high voltages are necessary during the memory programming phases, there is a breakdown risk of this dielectric layer which would lead to a device failure

Prior art documents US-A-5338969 and EP-A-0002997 already disclose memory cells with floating gate transistors manufactured by means of a self-aligned etching of the Poly2/interpoly/Poly1 sequence. In both documents a contact to the control gate is realized aligned to the central portion of the active area of the floating gate transistor.

### Summary of the invention

The invention achieves this aim, as well as other objects and advantages as will become apparent from the description.

The solution idea standing behind the invention is that of eliminating the POLY1 mask from the process and to modify the cell layout in order to define the floating gates just by the POLY2 mask and the Self-Aligned Poly2/interpoly/Poly1 stack etching.

The control gate line will be realized by a metal interconnection which is electrically connected to the second polisilicon layer, which represent the physical control gate, and by means of a standard contact on every bit of the memory array.

On the base of that solution idea the above aims are achieved with a non-volatile memory structure wherein a contact is provided on a polywing of the control gate located on field oxide regions, as defined in claim 1.

A process for manufacturing the mamery structure according to the invention is defined in claim 5.

The feature and advantages of the non volatile memory structure according to the invention will be appreciated from the following description of a preferred embodiment given by way of non-limiting example with reference to the enclosed drawings.

### Brief description of the drawings

Figure 1A is an enlarged scale cross sectional view of a semiconductor EEPROM memory cell of known type, the view is taken along line A of Figure 1C;
Figure 1B is a cross sectional view of the semiconductor EEPROM memory cell of Figure 1A, the view is taken along line B of Figure 1C;
Figure 1C is a top plan view of an EEPROM memory cell according to the prior art;
Figure 1D is a cross sectional view of the semiconductor EEPROM memory cell of Figure 1A, the view is taken along line C of Figure 1C;
Figure 2A is an enlarged scale cross sectional view of a semiconductor EEPROM memory cell of known type the view is taken along line I-I of Figure 2C;
Figure 2B is a cross sectional view of the semiconductor EEPROM memory cell of Figure 2A, the view is taken along line II-II of Figure 2C;
Figure 2C is a top plan view of an EEPROM memory cell of known type;
Figure 2D is a cross sectional view of the semiconductor EEPROM memory cell of Figure 2A, the view is taken along line III-III of Figure 2C;
Figure 3A is an enlarged scale cross sectional view of an embodiment of a semiconductor EEPROM memory cell according to the invention, the view is taken along line I-I of Figure 3C;
Figure 3B is a cross sectional view of the semiconductor EEPROM memory cell of Figure 3A, the view is taken along line II-II of Figure 3C;
Figure 3C is a top plan view of an EEPROM memory cell according to an embodiment of the present invention;
Figure 3D is a cross sectional view of the semiconductor EEPROM memory cell of Figure 3A, the view is taken along line C2 of Figure 3C;
Figure 4A is an enlarged scale cross sectional view of a semiconductor EPROM or Flash-EEPROM memory cell of known type, the view is taken along line I-I of Figure 4C;
Figure 4B is a cross sectional view of the semiconductor EPROM or Flash-EEPROM memory cell of Figure 4A, the view is taken along line II-II of Figure 4C;
Figure 4C is a top plan view of a semiconductor EPROM or Flash-EEPROM memory cell of known type;
Figure 4D is a cross sectional view of the semiconductor EPROM or flash EEPROM memory cell of Figure 4A, the view is taken along line III-III of Figure 4C;
Figures 5A, 5B and 5C are enlarged scale top plan views of an EEPROM memory cell according to the prior art and according to an embodiment of the present invention, respectively;
Figures 6A and 6B show an enlarged scale layout portion of a semiconductor non-volatile memory device including a source line contact region and a byte switch region realized according to the prior art, respectively;
Figures 7A and 7B show an enlarged scale layout portion of a semiconductor non-volatile memory device including a source line contact region and a byte switch region realized according to another example, respectively;
Figures 8A and 8B show an enlarged scale layout portion of a semiconductor non-volatile memory device including a realized according to an embodiment of the present invention, respectively.

### Detailed description

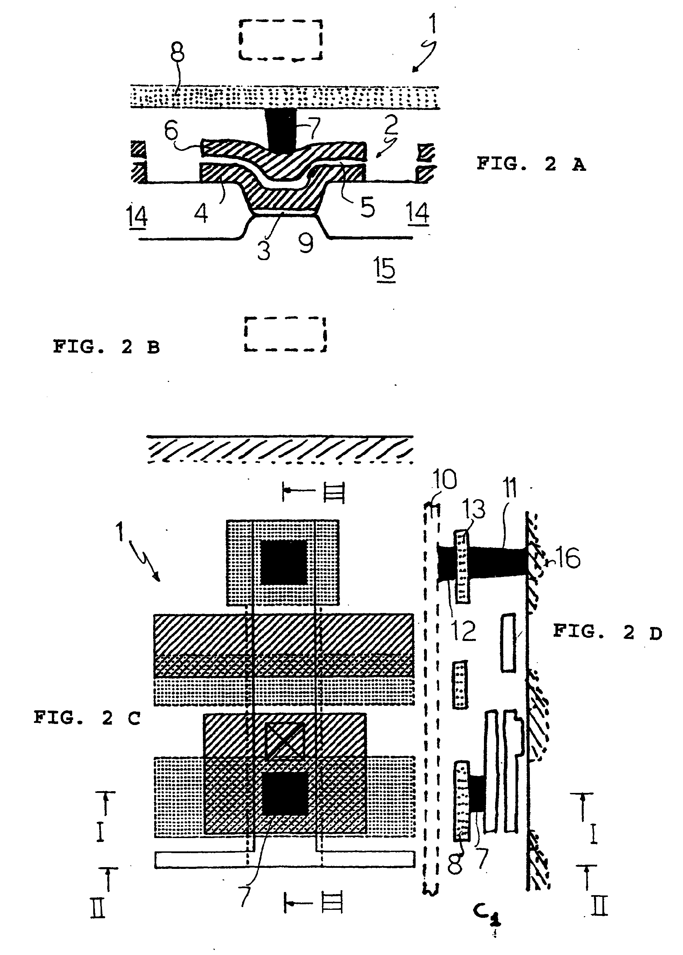

With reference to the above Figures, and more specifically to the example of Figure 2A, 2B, 2C and 2D, a non volatile memory cell is globally indicated with 1.

Referring to the drawing views, generally shown at 1 is the EEPROM memory cell which is integrated on a semiconductor substrate 15 of the P conductivity type and includes two levels of polysilicon.

Reference will be made in the ensuing description to a preferred embodiment employing devices of the N conductivity type. For devices of the P conductivity type, the types of conductivities mentioned hereinafter would have to be reversed.

The memory cell 1 comprises a floating gate transistor and an associated selection transistor for selecting a cell to be programmed from a group of cells in a memory matrix.

The floating gate transistor comprises an active area and a drain region 16' and a source region 17. The active area is delimited by field oxide regions 14. The drain region 16' is formed by an N-type implant in the substrate 15.

The source region 17 of the cell 1 is formed by implanting the substrate 15 with a dopant of the N conductivity type.

The substrate region 15 provided between the drain 16' and source 17 regions forms the active area channel region 9 of the floating gate transistor. The channel 9 is overlaid by a gate region 2 in an isolated manner with the interposition of an oxide layer 3. In known way, the gate region 2 conventionally comprises a floating gate and control gate.

The gate region 2 comprises a stack aligned structure including a tunnel oxide 3 layer, a first polysilicon (poly1) layer 4, an interpoly dielectric 5 layer and a second polysilicon (poly2) 6 layer.

The memory cell 1 is manufactured without a POLY1 mask. The cell layout has been modified, if compared to the prior art solutions, and the floating gate has been defined in both directions I-I and II-II with the POLY2 mask and the Self-Aligned poly2/interpoly/poly1 stack etching.

The cell layout is clearly shown in Figure 2C.

A control gate contact 7 is provided over the second poly2 layer 6. This contact 7 is provided on the gate region 2 over the active area and substantially aligned to the central portion of the channel area 9.

A first metallization layer 8 is provided to strap the floating gate transistor forming the cell 1 to a selection transistor serially connected on the drain side. and not shown being of a conventional type.

The bit line of the memory array is realized by a second metallization level 10 and by an electrical connection 11 to the drain of the cell 1. More specifically, the electric connection to the drain 16 of the cell 1 is realized by means of a stacked contact which is connected to first metal layer 8 and by a contact via 12 between the first metal layer and the second metal layer 10. A first metal layer island 13 is provided around the contact via 12 with appropriate dimension to avoid any problem in case of misalignement.

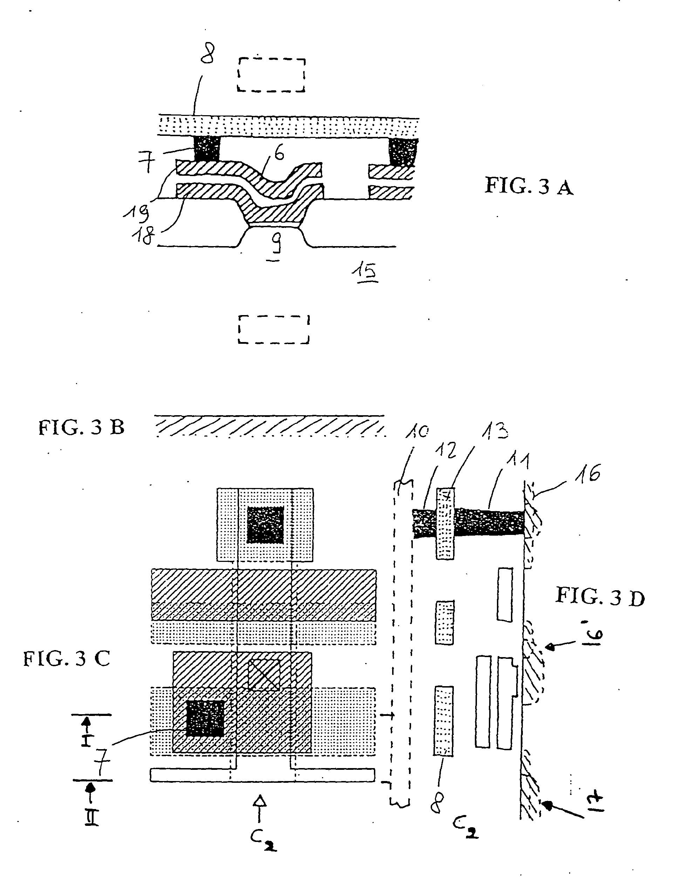

An embodiment of the memory cell according to the present invention is shown in figures 3A, 3B, 3C and 3D.

The main difference between this alternative layout solution and the previous example is that the control gate contact 7 between the second poly2 layer 6 and the first metal layer 8 is placed on field oxide and not above the active area.

In order to obtain this configuration, a poly1 wing 18 and a poly2 wing 19 are provided to define the control gate capacitive coupling of the floating gate transistor. These wings 18, 19 are asymmetric with respect to the gate active area of the non volatile memory cell 1.

The advantage of this solution is that the contact 7 is realized on a flat region.

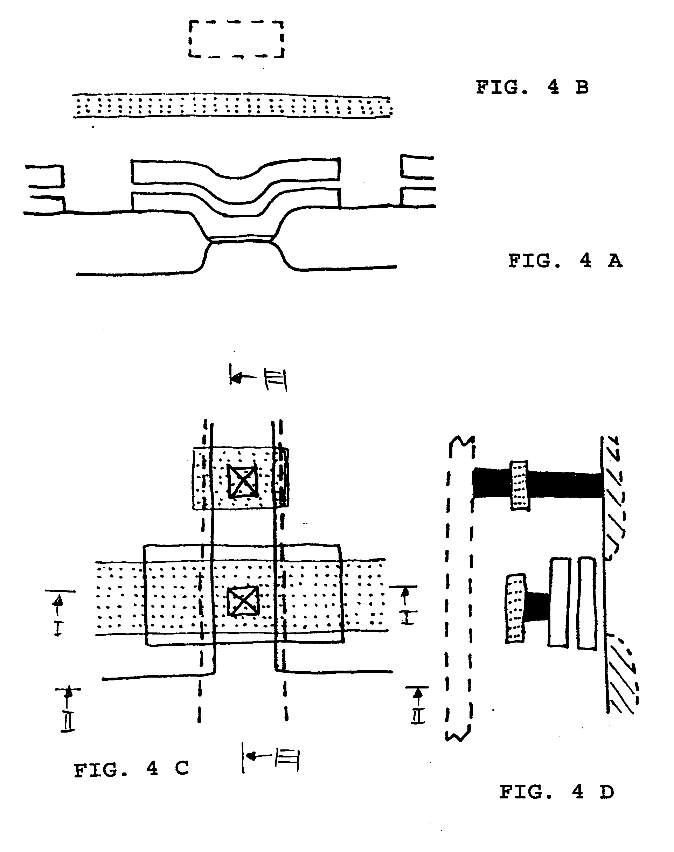

The principle of the present invention may applied to a Flash-EEPROM or to an EPROM cell, as depicted in figure 4.

Hereinafter, we will take in consideration the sequence of process phases which are required to obtain either of the example of figure 2 and the embodiment of figure 3.
1) standard operations of a double-poly CMOS process are provided for non volatile memories up to poly1 deposition
2) interpoly deposition over the poly1 layer 4;
3) a MATRIX mask is used to remove the interpoly dielectric layer 5 outside the memory array;
4) poly2 deposition is performed over the whole circuit layout;
5) a POLY2 or control gates mask is used to expose and define the control gates regions;
6) a poly2/interpoly/poly1 stack etching is provided to define the gate stack structures of the memory array;
7) standard phases are then provided for Source/Drain junction engineering depending on the kind of memory cell; possible salicide formation, interlevel dielectric deposition, contact opening; etc...
8) Advantageously, no implant in the control gate contacts 7, poly2 to first metal, are performed in order to reduce the danger of excessive contamination and possible interpoly dielectric degradation.
   As an alternative, when salicidation steps are provided and no implant in the contact is required, a dedicated mask present for implanting N+ dopant just for N-type contacts can be generated so that the control gate is protected from the implant.
9) The process steps are then completed in a standard manner.

Therefore, according to the invention, the POLY1 mask has been eliminated from the process steps and the cell layout has been modified in order to define the floating gates just by the POLY2 mask and the Self-Aligned Poly2/interpoly/Poly1 stack etching.

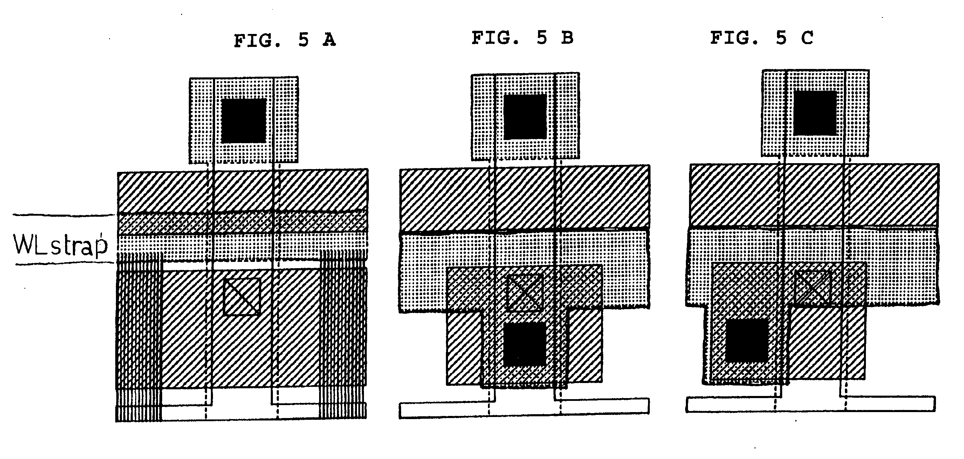

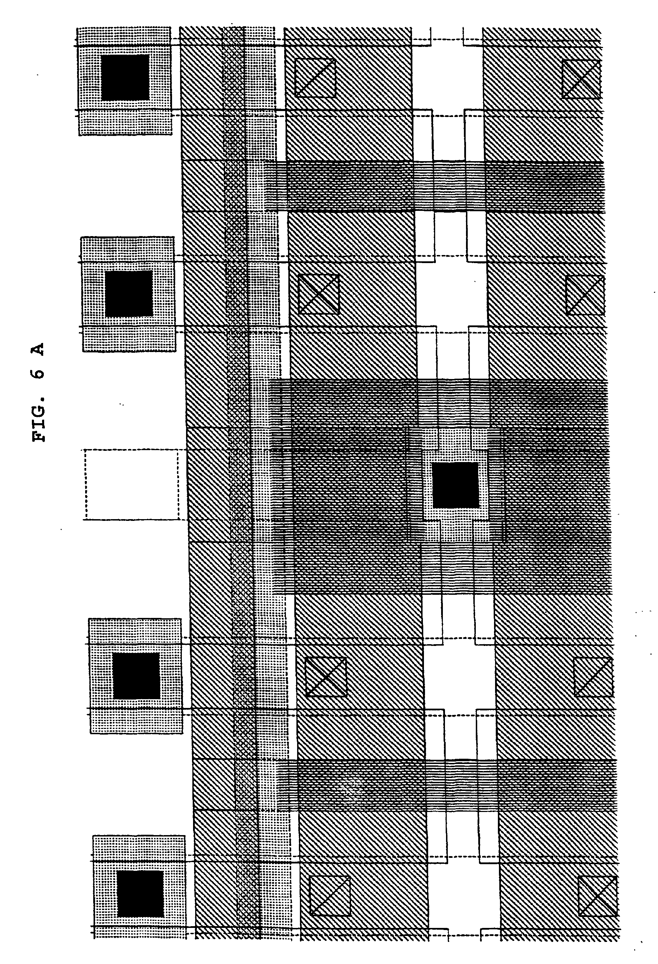

Now, with specific reference to the example shown in figure 5B, a slightly different layout is reported. If compared to the first example previously disclosed, the first metal layer of the control gate has a slightly different shape and it doesn't completely overlap the control gate.

Therefore, the metal1 control-gate line doesn't overlap the polyl/poly2 floating gate region, but it presents a lateral extension over the gate region in order to overlap the poly2/metal1 contact. A layout of a prior art solution is also reported in figure 5A.

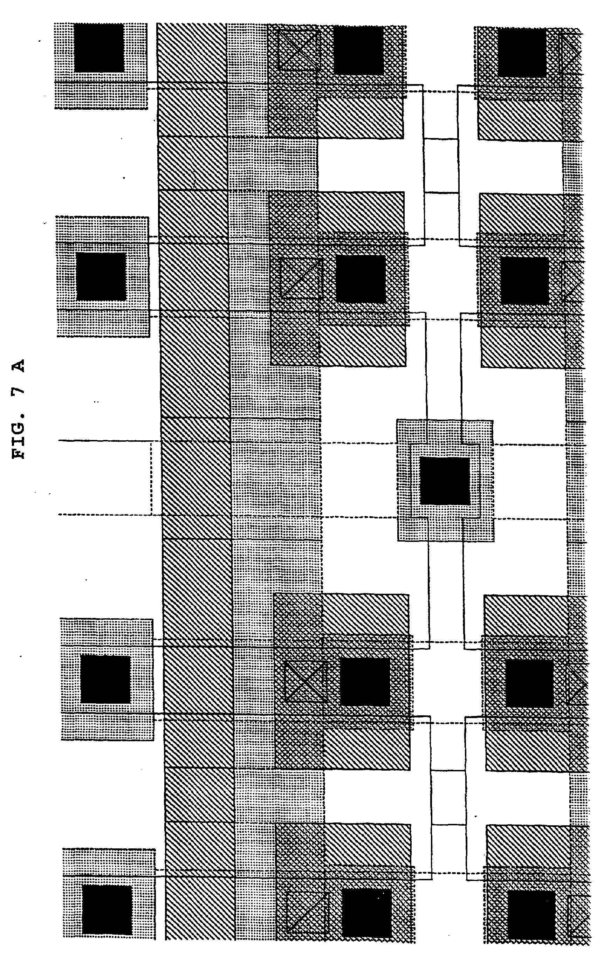

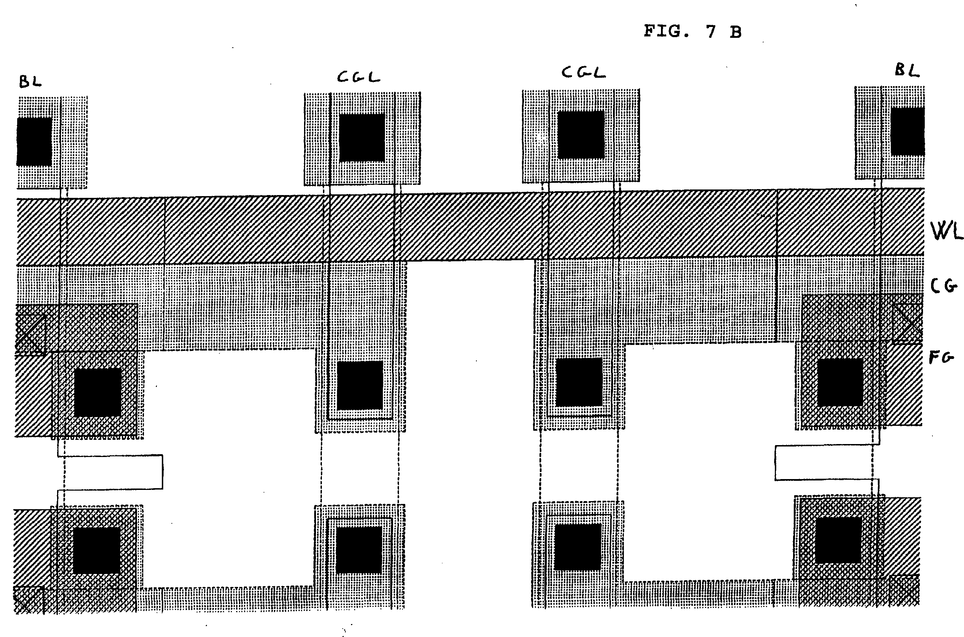

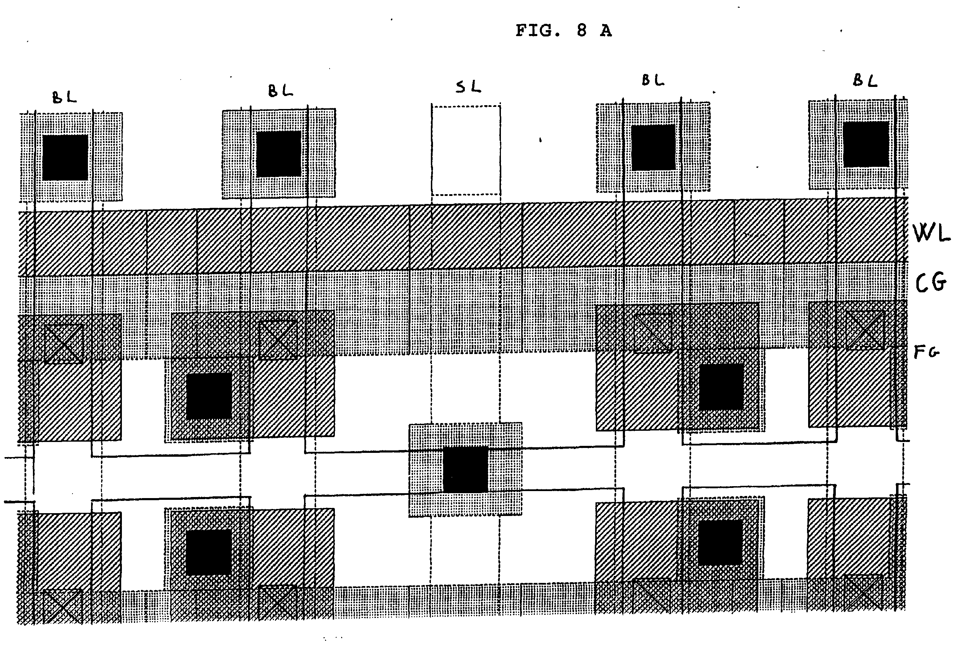

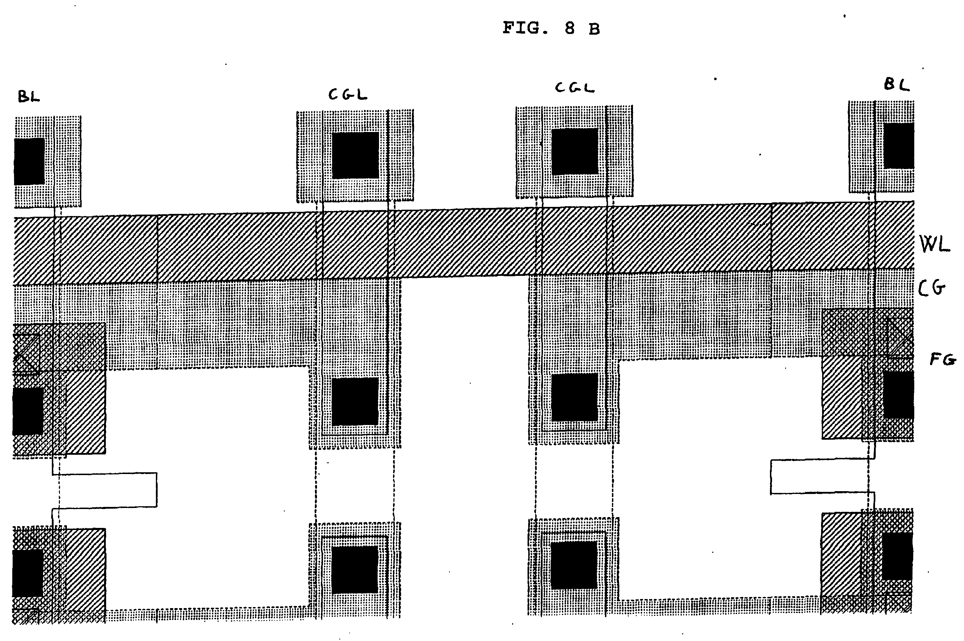

The layout shown in the figures 5A and 5B is used as a best mode to realize a memory array having a more compact structure, as shown in figures 7A, 7B and 8A, 8B. It worth to note, however, that the cell structure shown in figure 2 and 3 may be implemented as well to obtain an integrated memory array.

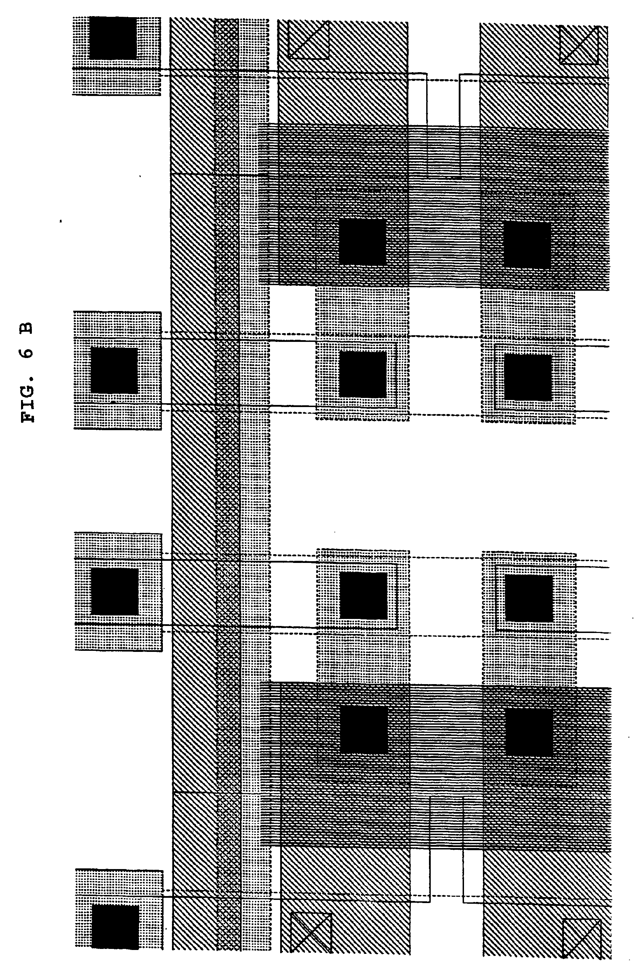

For a better understanding of the invention, figures 6a and 6b show a layout portion of a prior art solution concerning an EEPROM integrated memory array in the region wherein the source line is contacted and in the region wherein a byte is switched, respectively.

A corresponding layout portion obtained with a memory cell having a gate contact over the active area is shown in figures 7A and 7B respectively. Those figures relate to the first embodiment of the present invention

As may be appreciated, more room is available in the region of the byte switch (Fig.7b) with respect to the prior art solution shown in Fig. 6A, 6B. The metall control-gate line can be made shorter than the one illustrated in the figure 6B where the same footprint was kept in order to show the extra space.

A further layout portion obtained with the embodiment of the memory cell according to the invention is shown in figures 8A and 8B.

Even in this case it may be appreciated that more room is available both in the region of the byte switch (Fig.8B) and in the region wherein the source is contacted (Fig.8A).

This is due to the asymmetry of the floating gates with respect to bit-line active areas, so that the space needed to accomodate the contact on the source is less. The critical rule is the contact distance to polysilicon.

Also in this case the same footprint approach, as in the standard solution of Figures 6A and 6B, has been kept in order to show the extra space.

## Claims

1. A non-volatile memory structure integrated on a semiconductor substrate and including a plurality of memory cells (1) each comprising a floating gate transistor realized in an active area (9) delimited by field oxide regions (14) and having source/drain (17, 16') regions as well as a control gate coupled to the floating gate, the floating gate transistor being serially connected to a selection transistor, each memory cell (1) having source/drain (16, 17) regions, **characterized by** that said control gate and floating gate comprise respectively a poly wing (19, 18) lying on said field oxide regions (14) and
a control gate line realized by a metal interconnection layer (8) which is electrically connected to each control gate of the memory cells (1) by a contact (7) realized on said poly wing (19).

2. A memory structure according to claim 1, wherein a second metal interconnection layer (10) is provided to form a bit line contacting the drain region (16) of the cells (1) .

3. A memory structure according to claim 2, wherein the electric connection of the bit line to the drain (16) of the cell (1) is realized by means of a contact connected to the first metal layer (8) and by a contact via (12) between the first metal layer (8) and the second metal layer (10).

4. A memory structure according to claim 3, wherein a metal layer island (13) made of the first metal layer (8) is provided around said contact via (12).

5. A process for manufacturing by CMOS process steps a non-volatile memory structure integrated on a semiconductor substrate and including a plurality of memory cells (1) each comprising a floating gate transistor realized in an active area (9) delimited by field oxide regions (14) and having source/drain (17, 16') regions as well as a control gate coupled to the floating gate, the floating gate transistor being serially connected to a selection transistor, each memory cells (1) having source/drain (16, 17) regions, **characterized by** the fact that the floating gate is defined just by the mask used for defining the control gate and a Self-Aligned poly2/interpoly/poly1 stack etching, said control gate and floating gate comprising respectively a poly wing (19, 18) formed on said field oxide regions (14) and
a control gate line is formed by a metal interconnection layer (8) which is electrically connected to each control gate of the memory cells (1) by a contact (7) realized on said poly wing (19).

## Patentansprüche

1. Nicht-flüchtige Speicherstruktur, die auf einem Halbleitersubstrat integriert ist und eine Vielzahl von Speicherzellen (1) aufweist, von denen jede einen Transistor mit schwebendem Gate aufweist, der in einem durch Feldoxidbereiche (14) begrenzten aktiven Bereich (9) realisiert ist und der einen Source-/Drain-Bereich (17, 16') sowie ein mit dem schwebenden Gate gekoppeltes Steuergate aufweist, wobei der Transistor mit schwebendem Gate mit einem Auswähltransistor in Reihe geschaltet ist und jede Speicherzelle (1) einen Source-/Drain-Bereich (16, 17) aufweist,
**dadurch gekennzeichnet, dass** das Steuergate und das schwebende Gate jeweils einen Polysilizium-Flügel (19, 18) aufweisen, die auf den Feldoxidbereichen (14) liegen, und dass eine Steuergateleitung durch eine Metall-Zwischenverbindungsschicht (8) realisiert ist, die mit jedem Steuergate der Speicherzellen (1) durch einen an dem Polysilizium-Flügel (19) realisierten Kontakt (7) in Verbindung steht.

2. Speicherstruktur nach Anspruch 1,
wobei eine zweite Metall-Zwischenverbindungsschicht (10) zum Bilden einer Bitleitung vorgesehen ist, die mit dem Drain-Bereich (16) der Zellen (1) in Kontakt steht.

3. Speicherstruktur nach Anspruch 2,
wobei die elektrische Verbindung der Bitleitung mit dem Drain-Bereich (16) der Zelle (1) durch einen mit der ersten Metallschicht (8) verbundenen Kontakt sowie durch einen Kontaktdurchgang (12) zwischen der ersten Metallschicht (8) und der zweiten Metallschicht (10) gebildet ist.

4. Speicherstruktur nach Anspruch 3,
wobei eine aus der ersten Metallschicht (8) gebildete Metallschicht-Insel (13) um den Kontaktdurchgang (12) herum vorgesehen ist.

5. Verfahren zum unter Verwendung von CMOS-Herstellungsschritten erfolgenden Herstellen einer nicht-flüchtigen Speicherstruktur, die auf einem Halbleitersubstrat integriert ist und eine Vielzahl von Speicherzellen (1) aufweist, von denen jede eine Transistor mit schwebendem Gate aufweist, der in einem durch Feldoxidbereiche (14) begrenzten aktiven Bereich (9) realisiert ist und der einen Source-/Drain-Bereich (17, 16') sowie ein mit dem schwebenden Gate gekoppeltes Steuergate aufweist, wobei der Transistor mit schwebendem Gate mit einem Auswähltransistor in Reihe geschaltet ist und jede Speicherzelle (1) einen Source-/Drain-Bereich (16, 17) aufweist,
**dadurch gekennzeichnet, dass** das schwebende Gate lediglich durch die zum Definieren des Steuergates verwendete Maske sowie durch einen selbstausfluchtenden Poly2-/Zwischenpoly-/Poly1-Stapel-Ätzvorgang definiert wird, wobei das Steuergate und das schwebende jeweils einen Polysilizium-Flügel (19, 18) aufweisen, die auf den Feldoxidbereichen (14) gebildet sind, und dass eine Steuergateleitung durch eine Metall-Zwischenverbindungsschicht (8) gebildet wird, die mit jedem Steuergate der Speicherzellen (1) durch einen an dem Polysilizium-Flügel (19) realisierten Kontakt (7) in Verbindung steht.

## Revendications

1. Structure de mémoire non volatile intégrée à un substrat de semi-conducteurs et comprenant une pluralité de cellules de mémoire (1) chacune comprenant un transistor à grille flottante réalisé dans une zone active (9) délimitée par des régions d'oxyde de champ (14) et ayant des régions de source/drain (17, 16') ainsi qu'une grille de commande couplée à la grille flottante, le transistor à grille flottante étant connecté en série à un transistor de sélection, chaque cellule de mémoire (1) ayant des régions de source/drain (16, 17), **caractérisée en ce que** ladite grille de commande et ladite grille flottante comprennent respectivement une poly aile (19, 18) reposant sur lesdites régions d'oxyde de champ (14) et une ligne de grille de commande réalisée par une couche d'interconnexion métallique (8) qui est électriquement connectée à chaque grille de commande des cellules de mémoire (1) par un contact (7) réalisé sur ladite poly aile (19).

2. Structure de mémoire selon la revendication 1, dans laquelle une deuxième couche d'interconnexion métallique (10) est fournie pour former une ligne binaire en contact avec la région de drain (16) des cellules (1).

3. Structure de mémoire selon la revendication 2, dans laquelle la connexion électrique de la ligne binaire sur le drain (16) de la cellule (1) est réalisée au moyen d'un contact connecté à la première couche métallique (8) et par une voie de contact (12) entre la première couche métallique (8) et la deuxième couche métallique (10).

4. Structure de mémoire selon la revendication 3, dans laquelle un îlot de couche métallique (13) constitué de la première couche métallique(8) est fourni autour de ladite voie de contact (12).

5. Processus de fabrication par des étapes de processus CMOS d'une structure de mémoire non volatile intégrée à un substrat de semi-conducteurs et comprenant une pluralité de cellules de mémoire (1) chacune comprenant un transistor à grille flottante réalisé dans une zone active (9) délimitée par des régions d'oxyde de champ (14) et ayant des régions de source/drain (17, 16') ainsi qu'une grille de commande couplée à la grille flottante, le transistor à grille flottante étant connecté en série à un transistor de sélection, chaque cellule de mémoire (1) ayant des régions de source/drain (16, 17), **caractérisé par le fait que** la grille flottante est définie juste par le masque utilisé pour définir la grille de commande et une gravure de pile poly2/interpoly/polyl auto alignée, ladite grille de commande et ladite grille flottante comprenant respectivement une poly aile (19, 18) formée sur lesdites régions d'oxyde de champ (14) et
une ligne de grille de commande est formée par une couche d'interconnexion métallique (8) qui est électriquement connectée à chaque grille de commande des cellules de mémoire (1) par un contact (7) réalisé sur ladite poly aile (19).
